# EUROPEAN PATENT APPLICATION

(11) **EP 4 152 374 A1**
(43) Date of publication of application: **22.03.2023**
(21) Application number: 22191102.7
(22) Date of filing: 18.08.2022
(51) Int. Cl.: H01L 23/15, H01L 23/48, H05K 3/46, H01L 23/538, H01L 21/48

(54) **MOAT PROTECTION TO PREVENT CRACK PROPAGATION IN GLASS CORE SUBSTRATES OR GLASS INTERPOSERS**

(30) Priority: 21.09.2021 US 202117481257
(71) Applicant: INTEL Corporation, Santa Clara, CA 95054 (US)
(72) Inventor: PIETAMBARAM, Srinivas V., Chandler, 85297 (US); MANEPALLI, Rahul N., Chandler, 85249 (US); TANIKELLA, Ravindra, Chandler, 85226 (US)
(74) Representative: 2SPL Patentanwälte PartG mbB

(57) **Abstract**

Embodiments disclosed herein include electronic packages and methods of assembling such electronic packages. In an embodiment, an electronic package comprises a core, where the core comprises glass. In an embodiment, a hole is through a thickness of the core, and a plug fills the hole, where the plug comprises a polymeric material. In an embodiment, first layers are over the core, where the first layers comprise a dielectric material; and second layers are under the core, where the second layers comprise the dielectric material.

## Description

### TECHNICAL FIELD

Embodiments of the present disclosure relate to electronic packages, and more particularly to electronic packages that include a glass core with a moat to prevent crack propagation and/or thermal vias for improved heat dissipation through a glass core.

### BACKGROUND

Transistor shrinkage is becoming more difficult and costly from a manufacturing point of view. As a result, advanced packaging solutions, such as heterogeneous integration of active components to improve performance and functionality, are gaining popularity. Heterogeneous integration uses a packaging technology where dissimilar chips with different functionalities are integrated within the package using lateral connections (e.g., 2.5D embedded bridge architectures) or vertical connections (e.g., 3D die stacking).

As devices continue to scale, it is becoming more evident that manufacturing these types of packages is enabled by the use of a rigid carrier, such as a glass based carrier that is detachable using temporary bonding and debonding technology. The temporary rigid glass substrate enables handling of thinned chips and the grinding of dielectric materials for revealing lithographically defined plated vias. Further the low total thickness variation (TTV) of approximately 10µm or less associated with glass enables the ability to meet stringent via to pad overlay for fine pitch scaling.

One of the challenges associated with temporary bonding and debonding technology is that the package substrates warp or shrink after removal of the rigid carrier. Once the rigid carrier is debonded post first level interconnect (FLI) bump formation, the substrate is expected to warp due to inbuilt residual stress and CTE mismatch between various components (e.g., silicon, buildup film, and copper). This in turn can impact the back-end process for mid-level interconnect (MLI) or package side bump formation. Additionally, difficulties arise with thermocompression bonding (TCB).

One way to address the above problem is to use glass as a permanent core in the package substrate. As such, the rigidity is maintained through the process and into the final product. Using a glass core necessitates the need to make copper interconnect connections through the glass from one side to the other. These copper connections, known as through glass vias (TGVs) can cause crack or defect generation in the glass due to the CTE mismatch between glass and copper. The cracks can continue to propagate through the glass core and may result in defects that ruin the package substrate.

In addition to crack propagation issues, glass cores also negatively impact the thermal performance of the electronic package, particularly, the glass core has a low thermal conductivity. During thermocompression bonding (TCB) processes, dissipating thermal energy through the glass core is challenging. As such, defects during TCB processes is a common defect that needs to be accounted for.

### BRIEF DESCRIPTION OF THE DRAWINGS

Figure 1A is a cross-sectional illustration of a glass core with vias that initiate cracks in the glass core, in accordance with an embodiment.
Figure 1B is a cross-sectional illustration of a glass core with vias that initiate cracks in the glass core, where a barrier stops the propagation of the cracks, in accordance with an embodiment.
Figure 1C is a cross-sectional illustration of a glass core with vias that initiate cracks in the glass core, where a barrier with an embedded via stops the propagation of the cracks, in accordance with an embodiment.
Figure 2A is a cross-sectional illustration of an electronic package with a glass core and a barrier to prevent crack propagation, in accordance with an embodiment.
Figure 2B is a plan view illustration of a core with a plurality of barriers around a perimeter of the core, in accordance with an embodiment.
Figure 2C is a plan view illustration of a core with a continuous barrier around a perimeter of the core, in accordance with an embodiment.
Figure 3A is a cross-sectional illustration of an electronic package with a glass core and a barrier with embedded vias to prevent crack propagation, in accordance with an embodiment.
Figure 3B is a plan view illustration of a core with a plurality of barriers around a perimeter of the core, wherein the barriers have embedded vias, in accordance with an embodiment.
Figures 4A-4P are cross-sectional illustrations depicting a process for forming an electronic package with a glass core with crack propagation barriers, in accordance with an embodiment.
Figure 5 is a cross-sectional illustration of an electronic package with a via with a thermally conductive sleeve to aid in heat dissipation through a glass core, in accordance with an embodiment.
Figures 6A-6L are cross-sectional illustrations depicting a process for forming an electronic package with a glass core with sleeves around vias, in accordance with an embodiment.
Figure 7 is a schematic of a computing device built in accordance with an embodiment.

### EMBODIMENTS OF THE PRESENT DISCLOSURE

Described herein are electronic packages that include a glass core with a moat to prevent crack propagation and/or thermal vias for improved heat dissipation through a glass core, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

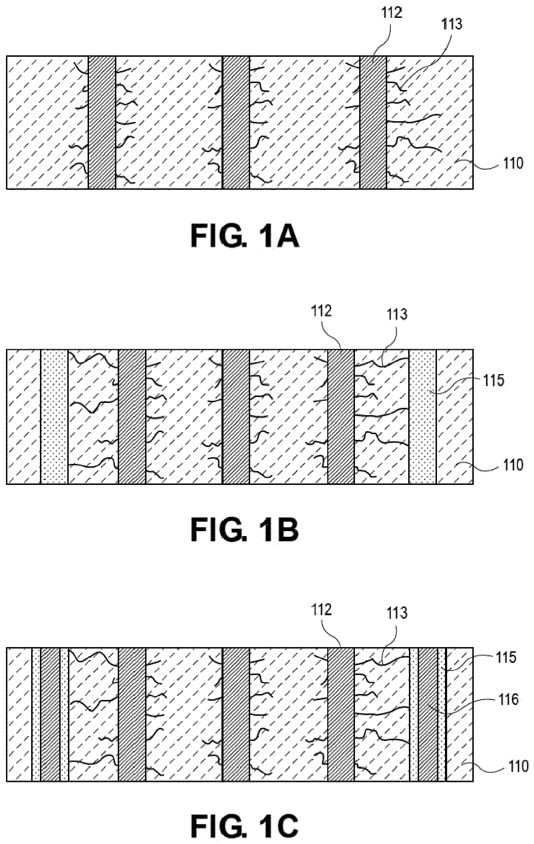

As noted above, through glass vias (TGVs) through a glass core can result in cracks or other defects in the glass due to the CTE mismatch between glass and copper. The cracks can continue to propagate through the glass core and may result in defects that ruin the package substrate. An example of the cracks is shown in Figure 1A. As shown, the vias 112 through the glass core 110 may result in the formation of cracks 113 that start at the via 112 and propagate outwards.

Accordingly, embodiments disclosed herein include the use of barriers that prevent further propagation of the cracks. An example of a barrier architecture is shown in Figure 1B. As shown, barriers 115 may pass through a thickness of the core 110. The cracks 113 may start at the via 112 and propagate out until they reach the barrier 115. The material that comprises the barrier 115 can be a material that is stress absorbing and/or that has a CTE that is between copper and glass. For example, the barrier 115 may comprise a resin plug, a buildup film, or an epoxy.

Referring now to Figure 1C, a cross-sectional illustration of a core 110 is shown, in accordance with an additional embodiment. As shown, the barrier 115 includes a via 116 that passes through the barrier 115. This results in the barrier 115 forming a sleeve around the via 116. Such an embodiment may be useful when there needs to be a vertical electrical connection through the area where the barrier 115 is needed.

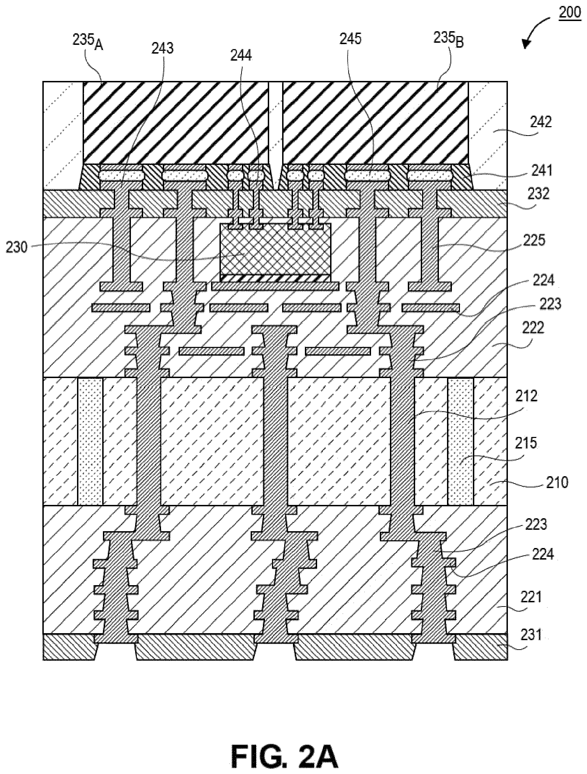

Referring now to Figure 2A, a cross-sectional illustration of an electronic package 200 is shown, in accordance with an embodiment. In an embodiment, the electronic package 200 comprises a core 210. The core 210 may comprise glass. That is, the core 210 may be considered a glass core 210 in some embodiments. In an embodiment, buildup layers 222 may be provided above the core 210, and buildup layers 221 may be provided below the core 210. In an embodiment, conductive routing (e.g., vias 223 and traces/pads 224) may be provided in the buildup layers 222 and 221.

In an embodiment, a bridge die 230 may be embedded in the buildup layers 222. The bridge die 230 may be coupled to bridge pads 244 over a solder resist 232. The bridge pads 244 may be coupled to dies 235_{A} and 235_{B} by a solder 245 so that the bridge die 230 communicatively couples the die 235_{A} to the die 235_{B}. The dies 235_{A} and 235_{B} may be surrounded by mold layer 242. The dies 235 may also be coupled to the pads 243 over the solder resist 232 by the solder 245. Solder 245 may be surrounded by underfill 241. Vias 225 may extend through the buildup layer 222 adjacent to the bridge die 230. In an embodiment, the backside surface of the buildup layers 221 may be covered by a solder resist 231. Openings in the solder resist 231 expose second level interconnect (SLI) pads.

In an embodiment, through glass vias (TGVs) 212 may pass through a thickness of the core 210. In an embodiment, the TGVs 212 comprise copper or any other suitable conductive material. The TGVs 212 provide electrical coupling between routing in the front side buildup layers 222 and the routing in the backside buildup layers 221. In the illustrated embodiment, the TGVs 212 have substantially vertical sidewalls. However, in other embodiments, the TGVs 212 may have tapered sidewalls.

As noted above, the CTE differences between the TGVs 212 and the core 210 may result in the generation of cracks in the core 210. As such, embodiments disclosed herein include barriers 215. The barriers 215 are provided around a perimeter of the core 210. Providing the barriers 215 around the perimeter of the core 210 allows for the cracks to reach the barriers 215 before reaching the edge of the core 210. In an embodiment, the barriers 215 may comprise a material that is stress absorbing and/or that has a CTE that is between copper and glass. For example, the barriers 215 may comprise a polymer such as a resin plug, a buildup film material, or an epoxy. In the illustrated embodiment, the barriers 215 have substantially vertical sidewalls. However, in other embodiments, the sidewalls of the barriers 215 may be tapered or the like.

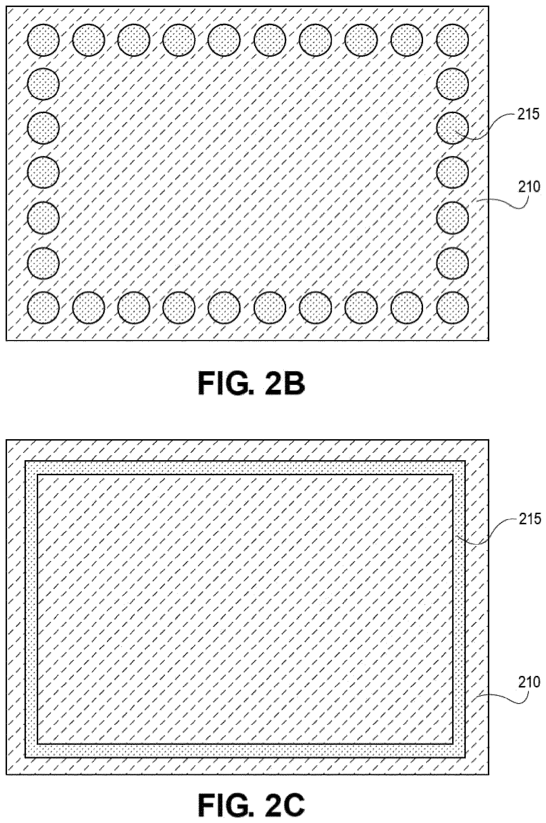

Referring now to Figure 2B, a plan view illustration of the core 210 is shown, in accordance with an embodiment. In Figure 2B, the TGVs are omitted for clarity, but it is to be appreciated that a plurality of TGVs may be provided through the core 210, as is shown in Figure 2A. As shown, a plurality of the barriers 215 may be provided around a perimeter of the core 210. The barriers 215 may have a substantially circular shape, though other shapes may also be used in some embodiments.

Referring now to Figure 2C, a plan view illustration of the core 210 is shown, in accordance with an additional embodiment. As shown, the barrier 215 may comprise a single continuous trench that runs proximate to the perimeter of the core 210. That is, the barrier 215 may be a single structure instead of a plurality of discrete structures, as shown in Figure 2B.

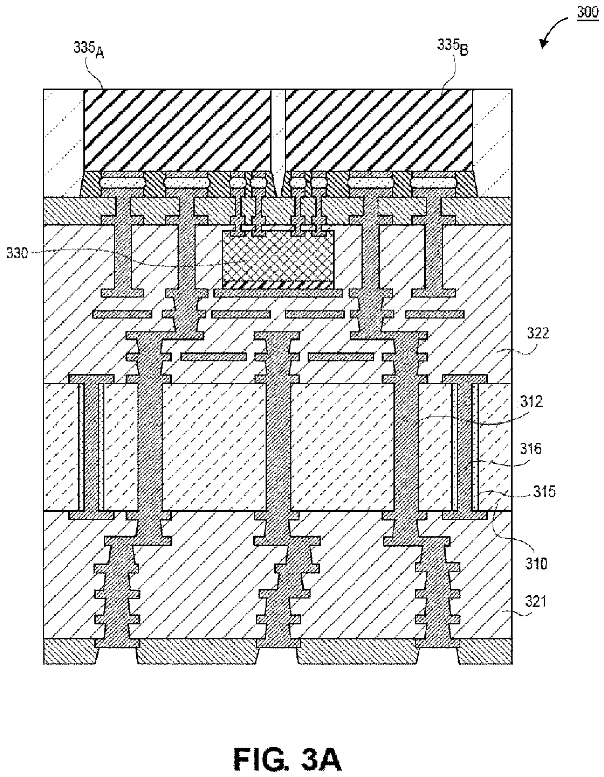

Referring now to Figure 3A, a cross-sectional illustration of an electronic package 300 is shown, in accordance with an additional embodiment. In an embodiment, the electronic package 300 may be substantially similar to the electronic package in Figure 2A, with the exception of the architecture of the barriers 315. For example, the electronic package 300 comprises a core 310 with TGVs 312. Buildup layers 322 may be formed above the core 310 and buildup layers 321 may be formed below the core 310. A bridge 330 in the buildup layers 322 may communicatively couple a first die 335_{A} to a second die 335_{B}.

In an embodiment, the barriers 315 may also comprise a vias 316. Forming a via 316 through the barrier 315 may allow for more signals or power lanes to pass through a thickness of the core 310. In an embodiment, the formation of the vias 316 result in the barriers 315 becoming sleeves that surround the vias 316. In the illustrated embodiment, the vias 316 have substantially vertical sidewalls. In other embodiments, the vias 316 may be tapered.

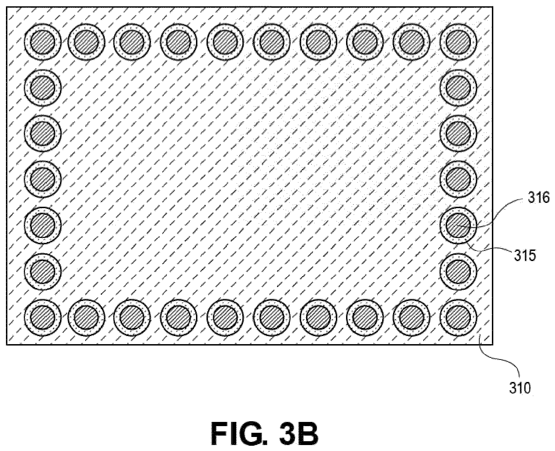

Referring now to Figure 3B, a plan view illustration of a core 310 is shown, in accordance with an embodiment. In Figure 3B, the TGVs are omitted for clarity, but it is to be appreciated that a plurality of TGVs may be provided through the core 310, as is shown in Figure 3A. As shown, a plurality of the barriers 315 may be provided around a perimeter of the core 310. The barriers 315 may have a substantially circular shape, though other shapes may also be used in some embodiments. As shown, the barriers 315 form a sleeve around vias 316 that pass through the core 310. In an embodiment, the vias 316 are dummy vias. That is, no signal or power may pass through the vias 316. In other embodiments, the vias 316 may be used for routing power and/or ground signals through the core 310.

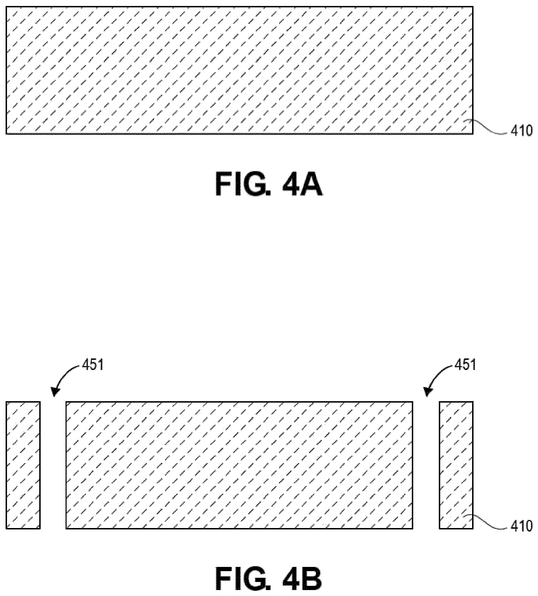

Referring now to Figures 4A-4P, a series of cross-sectional illustrations of a process for forming an electronic package is shown, in accordance with an embodiment. In an embodiment, the electronic package formed in Figures 4A-4P is substantially similar to the electronic package in Figure 3A. That is, vias are formed through the barriers. However, it is to be appreciated that similar processing operations with minor modifications may be used to form an electronic package similar to the electronic package shown in Figure 2A. In Figures 4A-4P, a single unit is shown. However, it is to be appreciated that multiple units may be formed substantially in parallel by using a large form factor glass, such as a panel level form factor or quarter panel level form factor.

Referring now to Figure 4A, a cross-sectional illustration of a core 410 is shown, in accordance with an embodiment. In an embodiment, the core 410 may comprise glass. That is, the core 410 may be a glass core in some embodiment. In an embodiment, the core 410 may have a thickness that is approximately 100µm or greater. In some embodiments, the thickness of the core 410 may be approximately 500µm or greater. The core 410 may comprise any suitable glass material for packaging applications. In an embodiment, the core 410 may comprise a glass with a CTE of approximately 3.5 or lower. As used herein "approximately" may refer to a range of values that is within 10% of the stated value. For example, approximately 100µm may refer to a range between 90µm and 110µm.

Referring now to Figure 4B, a cross-sectional illustration of the core 410 after first holes 451 are formed through a thickness of the core 410 is shown, in accordance with an embodiment. In an embodiment, the first holes 451 may be formed with a laser drilling process. In the illustrated embodiment, the sidewalls of the first holes 451 are substantially vertical. In other embodiments, the first holes 451 may have tapered sidewalls. In an embodiment, the first holes 451 may be formed proximate to an edge of the core 410. A plurality of first holes 451 may be formed. In other embodiments, a single continuous trench may be formed around a perimeter of the core 410.

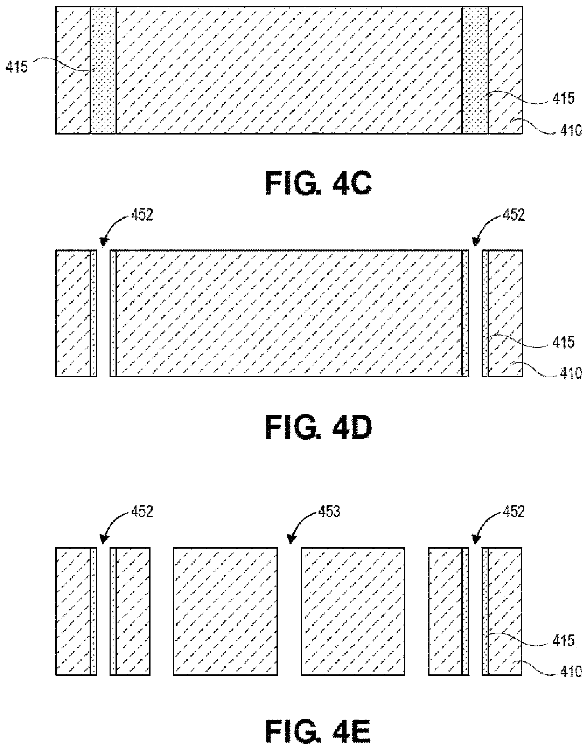

Referring now to Figure 4C, a cross-sectional illustration of the core 410 after the barriers 415 are disposed in the first holes 451 is shown, in accordance with an embodiment. In an embodiment, the barriers 415 may be disposed with a squeeze printing process or any other suitable material deposition process. In an embodiment, the barriers 415 may comprise a material that is stress absorbing and/or that has a CTE that is between copper and glass. For example, the barrier 415 may comprise a polymer such as a resin plug, a buildup film, or an epoxy. In some embodiments, the barrier 415 may be cured after being disposed in the first holes 451.

Referring now to Figure 4D, a cross-sectional illustration of the core 410 after second holes 452 are formed through the barriers 415 is shown, in accordance with an embodiment. In an embodiment, the second holes 452 are used to provide an opening that can be filled with vias. That is, in embodiments where there is no desire to include a via through the barriers 415 (e.g., similar to the embodiment shown in Figure 2A), the formation of the second holes 452 may be omitted. In an embodiment, the second holes 452 may be formed with a laser drilling process or a mechanical drilling process. In the illustrated embodiment, sidewalls of the second holes 452 are substantially vertical. In other embodiments, the sidewalls of the second holes 452 may be tapered.

Referring now to Figure 4E, a cross-sectional illustration of the core 410 after third holes 453 are formed through the core 410 is shown, in accordance with an embodiment. In an embodiment, the third holes 453 are formed with a laser drilling process or the like. In the illustrated embodiment, the third holes 453 have vertical sidewalls. In other embodiments, the third holes 453 may be tapered. In an embodiment, the third holes 453 are made at locations where TGVs are desired.

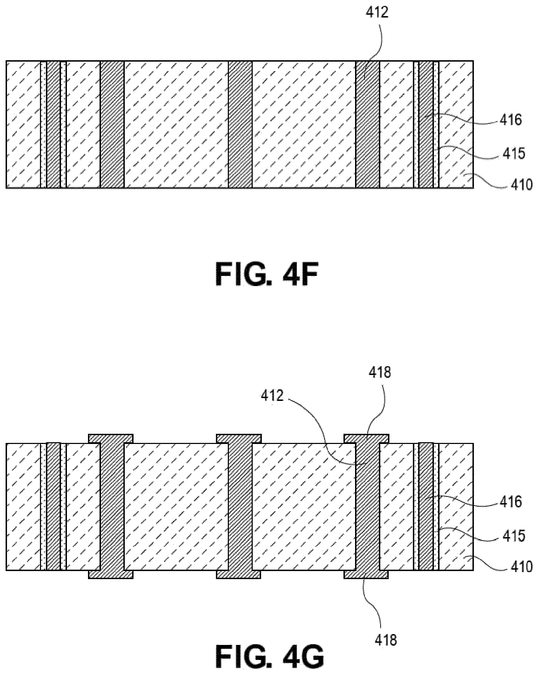

Referring now to Figure 4F, a cross-sectional illustration of the core 410 after the holes are plated is shown, in accordance with an embodiment. In an embodiment, any suitable plating process may be used to form TGVs 412 and vias 416. In an embodiment, excess copper over the top and bottom surface of the core 410 may be removed with a polishing or grinding process.

Referring now to Figure 4G, a cross-sectional illustration of the core 410 after pads 418 are formed over the TGVs 412 is shown, in accordance with an embodiment. In an embodiment, the pads 418 may be formed with a standard semi-additive process (SAP). In an embodiment, pads 418 are formed over the TGVs 412 only. However, when the vias 416 are used as part of the power network, pads 418 may also be formed over the vias 416. The pads 418 may be in direct contact with the core 410.

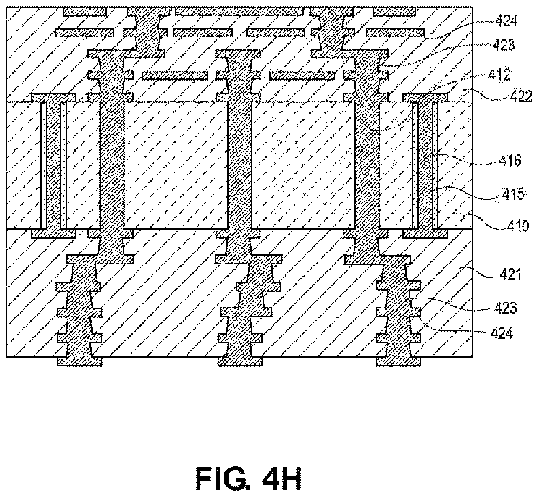

Referring now to Figure 4H, a cross-sectional illustration of the core 410 after buildup layers 422 are provided above the core 410 and buildup layers 421 are provided below the core 410 is shown, in accordance with an embodiment. In an embodiment, the buildup layers 422 and 421 may be deposited with a lamination process. In an embodiment, conductive routing is also provided in the buildup layers 422 and 421. For example vias 423 and traces/pads 424 are embedded within the buildup layers 422 and 421. The conductive features 423 and 424 may be formed with an SAP technique in some embodiments.

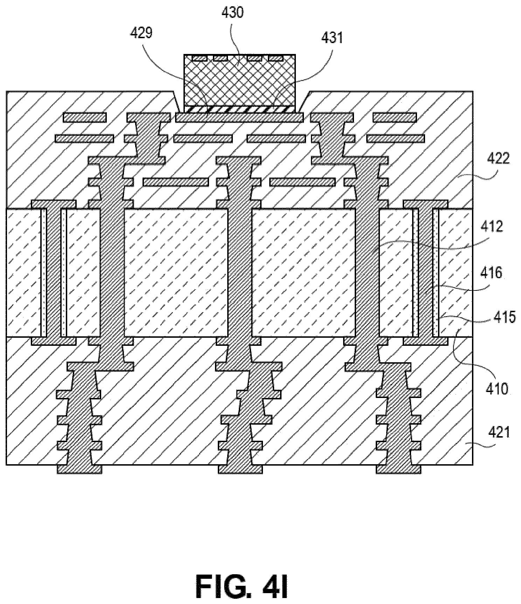

Referring now to Figure 4I, a cross-sectional illustration of the core 410 after a bridge die 430 is attached is shown, in accordance with an embodiment. In an embodiment, a buildup layer is laminated over the topmost layer 422 and a laser skiving process is used to expose a pad 429. The bridge die 430 is set in the opening and onto the pad 429. For example, the bridge die 430 may be coupled to the pad 429 by an adhesive, such as a die attach film (DAF) 431. In Figure 4I, the bridge die 430 is shown without any through substrate vias. However, it is to be appreciated that in other embodiments, the bridge die 430 may include through substrate vias. In such an embodiment, the bottom of the bridge die 430 may be coupled to pads by solder or the like, in order to allow for signals to pass through the bridge die 430.

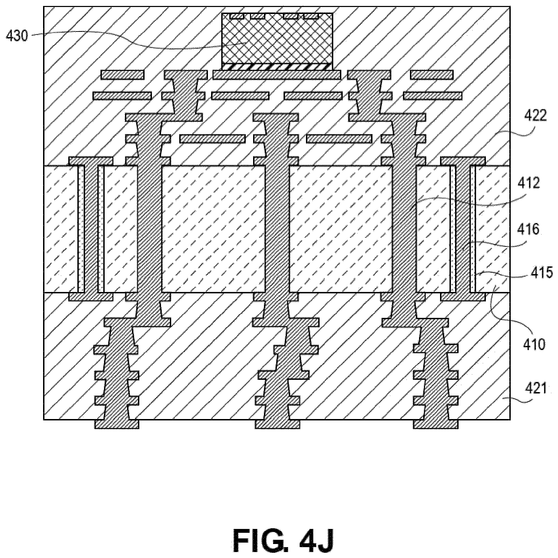

Referring now to Figure 4J, a cross-sectional illustration of the core 410 after a dielectric layer is laminated over the bridge die 430 is shown, in accordance with an embodiment. In an embodiment, the dielectric layer may be considered part of the buildup layers 422.

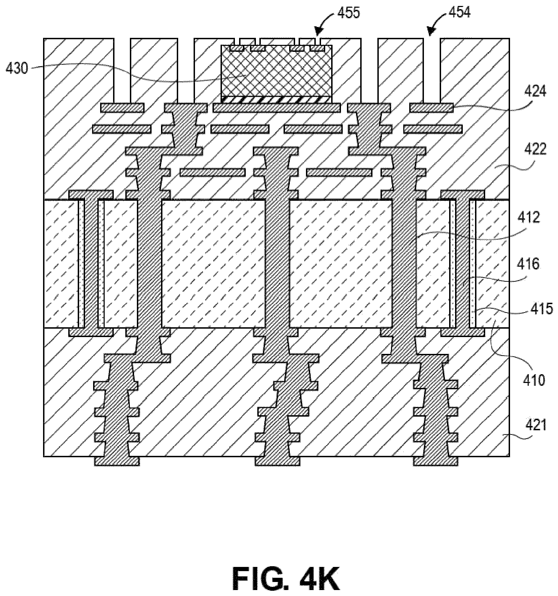

Referring now to Figure 4K, a cross-sectional illustration of the core 410 after holes 454 and 455 are formed into the buildup layers 422 is shown, in accordance with an embodiment. In an embodiment, the holes 454 extend into the buildup layers 422 and contact traces/pads 424 below the level of the bridge die 430. The holes 455 extend through the buildup layer and expose pads on the bridge die 430.

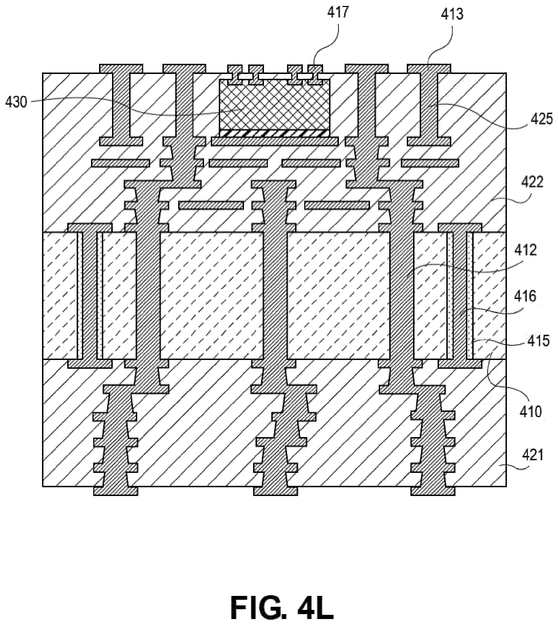

Referring now to Figure 4L, a cross-sectional illustration of the core 410 after the holes 454 and 455 are filled with a conductive material is shown, in accordance with an embodiment. In an embodiment, the conductive material forms vias 425 through the buildup layers 422. The vias 425 may be adjacent to the bridge die 430. Additionally, pads 413 and 417 may be formed over the topmost layer of the buildup layers 422.

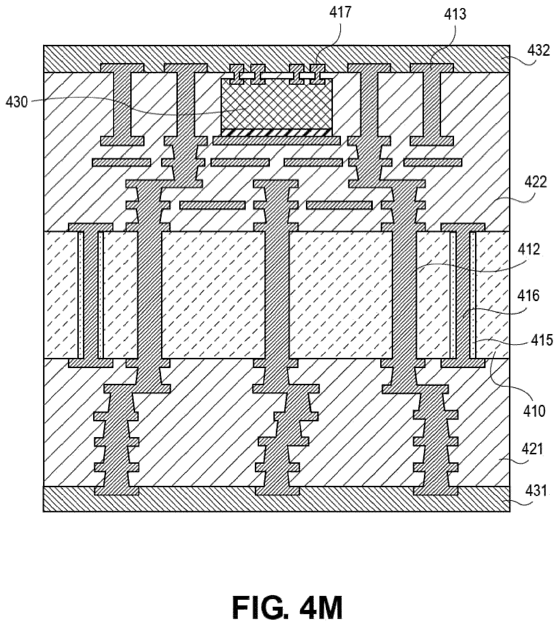

Referring now to Figure 4M, a cross-sectional illustration of the core 410 after solder resist layers 432 and 431 are provided over the buildup layers 422 and under the buildup layers 421. In an embodiment, the solder resist layers 432 and 431 may be formed with lamination process. In some embodiments, the solder resist layers 432 and 431 may be cured.

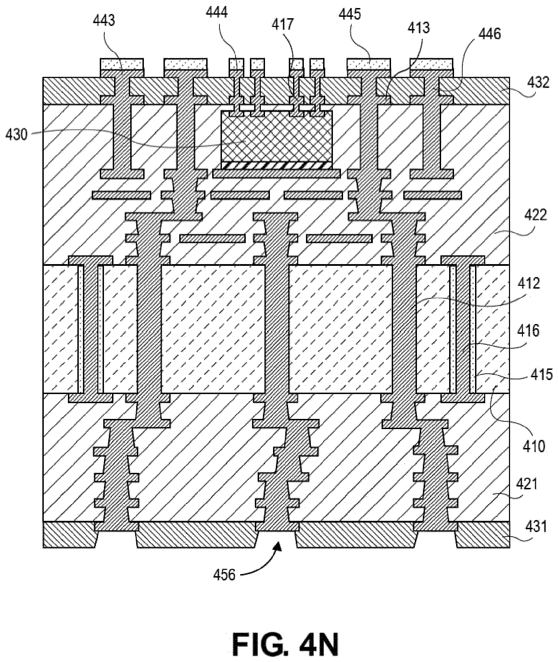

Referring now to Figure 4N, a cross-sectional illustration of the core 410 after first level interconnects (FLIs) are formed is shown, in accordance with an embodiment. In an embodiment, vias 446 extend through the solder resist layer 432 to contact the pads 413 and 417. FLI pads 443 and 444 may be provided over the vias 446. In an embodiment, a surface finish (not shown) is applied over the FLI pads 443 and 444. In some embodiments, a solder 445 is plated over the pads 443 and 444. In an embodiment, openings 456 are formed through the bottom solder resist layer 431 to expose pads for the second level interconnect (SLI) pads. The SLI pads may have a surface finish (not shown).

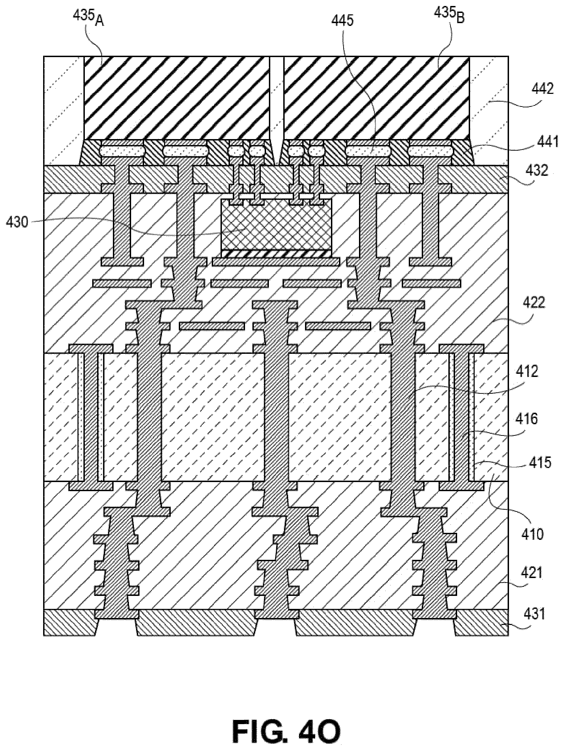

Referring now to Figure 4O, a cross-sectional illustration of the core 410 after a first die 435_{A} and a second die 435_{B} are attached is shown, in accordance with an embodiment. The dies 435 may be attached with the solder 445. In an embodiment, an underfill 441 may surround the solder 445. A mold layer 442 may be disposed around the dies 435. In an embodiment, the first die 435_{A} is communicatively coupled to the second die 435_{B} by the bridge die 430.

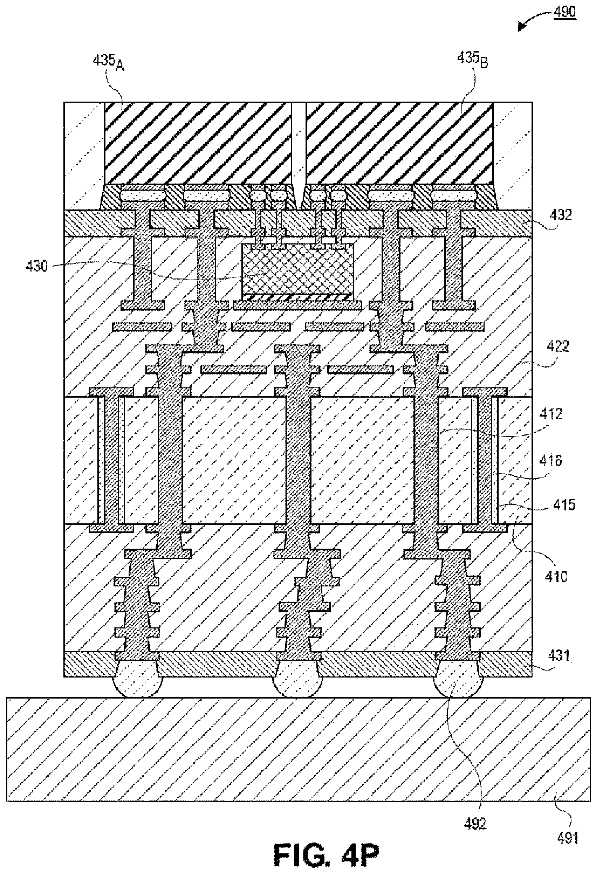

Referring now to Figure 4P, a cross-sectional illustration of an electronic system 490 is shown, in accordance with an embodiment. The electronic system 490 may comprise the structure shown in Figure 4O attached to a board 491, such as a printed circuit board (PCB). In an embodiment, the board 491 may be coupled to the package substrate by SLIs 492. In an embodiment, the SLISs 492 comprise a solder ball, but it is to be appreciated that other SLI architectures may also be used in some embodiments.

In addition to issues with crack propagation in glass cores, glass cores also suffer from low thermal conductivity through the glass core. This is particularly problematic during thermal compression bonding (TCB) processes. The low thermal conductivity of glass cored package complexes necessitates the need for thermal solutions to manage heating of the unit during TCB processes. Accordingly, embodiments disclosed herein include disposing a thermally conductive sleeve around the TGVs to increase the thermal dissipation efficiency during TCB processes and to minimize yield loss related to this assembly operation.

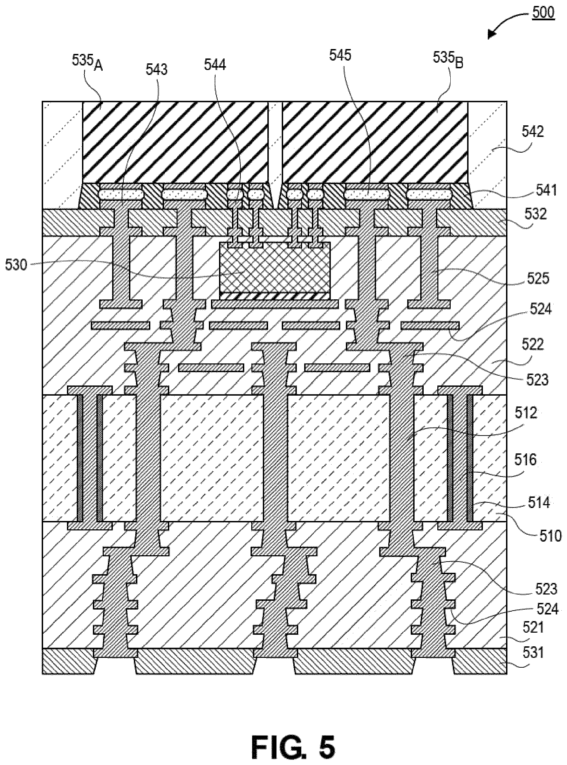

Referring now to Figure 5, a cross-sectional illustration of an electronic package 500 is shown, in accordance with an embodiment. In an embodiment, the electronic package 500 comprises a core 510. The core 510 may comprise glass. That is, the core 510 may be considered a glass core 510 in some embodiments. In an embodiment, buildup layers 522 may be provided above the core 510, and buildup layers 521 may be provided below the core 510. In an embodiment, conductive routing (e.g., vias 523 and traces/pads 524) may be provided in the buildup layers 522 and 521.

In an embodiment, a bridge die 530 may be embedded in the buildup layers 522. The bridge die 530 may be coupled to bridge pads 544 over a solder resist 532. The bridge pads 544 may be coupled to dies 535_{A} and 535_{B} by a solder 545 so that the bridge die 530 communicatively couples the die 535_{A} to the die 535_{B}. The dies 535 may also be coupled to the pads 543 over the solder resist 532 by the solder 545. Vias 525 may extend through the buildup layer 522 adjacent to the bridge die 530. In an embodiment, the backside surface of the buildup layers 521 may be covered by a solder resist 531. Openings in the solder resist 531 expose second level interconnect (SLI) pads.

In an embodiment, through glass vias (TGVs) 512 may pass through a thickness of the core 510. In an embodiment, the TGVs 512 comprise copper or any other suitable conductive material. The TGVs 512 provide electrical coupling between routing in the front side buildup layers 522 and the routing in the backside buildup layers 521. In the illustrated embodiment, the TGVs 512 have substantially vertical sidewalls. However, in other embodiments, the TGVs 512 may have tapered sidewalls.

As noted above, the thermal conductivity through the core 510 is low. Accordingly, embodiments disclosed herein include sleeves 514 that surround vias 516. The sleeves 514 may comprise a material that has a high thermal conductivity. In an embodiment, the sleeves 514 have a thermal conductivity that is higher than a thermal conductivity of the vias 516. For example, the sleeves 514 may comprise aluminum particles, or a silver containing paste. The high thermal conductivity of the sleeves 514 allows for improved thermal conductivity through the core 510. This is particularly beneficial for operations, such as TCB processes.

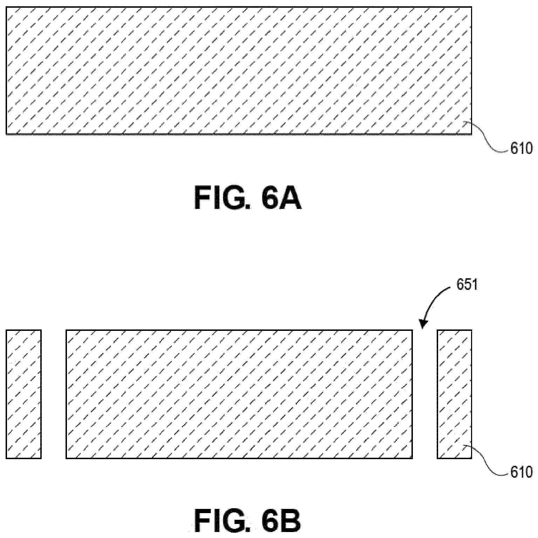

Referring now to Figures 6A-6L, a series of cross-sectional illustrations of a process for forming an electronic package is shown, in accordance with an embodiment. In an embodiment, the electronic package formed in Figures 6A-6L is substantially similar to the electronic package in Figure 5. In Figures 6A-6L, a single unit is shown. However, it is to be appreciated that multiple units may be formed substantially in parallel by using a large form factor glass, such as a panel level form factor or quarter panel level form factor.

Referring now to Figure 6A, a cross-sectional illustration of a core 610 is shown, in accordance with an embodiment. In an embodiment, the core 610 may comprise glass. That is, the core 610 may be a glass core in some embodiment. In an embodiment, the core 610 may have a thickness that is approximately 100µm or greater. In some embodiments, the thickness of the core 610 may be approximately 500µm or greater. The core 610 may comprise any suitable glass material for packaging applications. In an embodiment, the core 610 may comprise a glass with a CTE of approximately 3.5 or lower.

Referring now to Figure 6B, a cross-sectional illustration of the core 610 after first holes 651 are formed through a thickness of the core 610 is shown, in accordance with an embodiment. In an embodiment, the first holes 651 may be formed with a laser drilling process. In the illustrated embodiment, the sidewalls of the first holes 651 are substantially vertical. In other embodiments, the first holes 651 may have tapered sidewalls. In an embodiment, the first holes 651 may be formed proximate to an edge of the core 610.

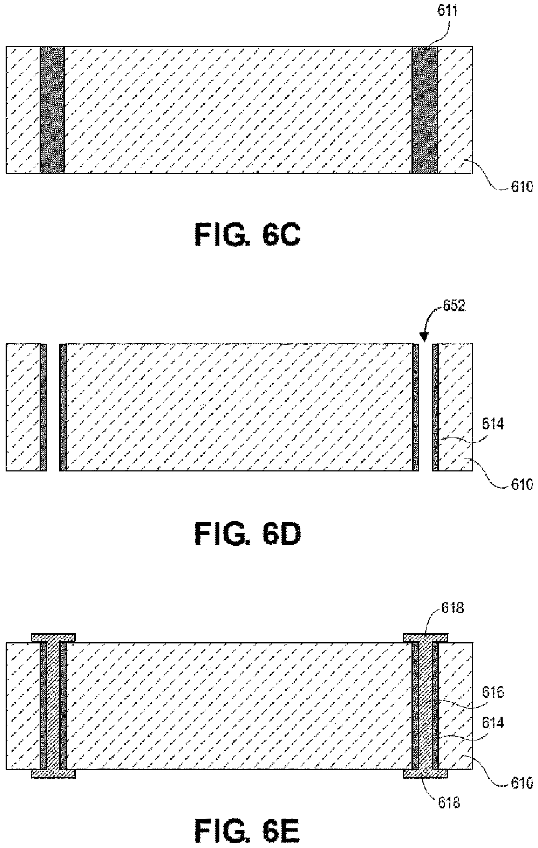

Referring now to Figure 6C, a cross-sectional illustration of the core 610 after plugs 611 are disposed in the first holes 651 is shown, in accordance with an embodiment. In an embodiment, the plugs 611 may comprise a thermally conductive material. In some embodiments, the plugs 611 are a paste that is squeeze printed into the first holes 651. For example, the plugs 611 may comprise a paste that comprises aluminum particles or silver particles. In an embodiment, after disposing the plugs 611 into the first holes 651, the plugs 611 may be cured.

Referring now to Figure 6D, a cross-sectional illustration of the core 610 after second holes 652 are drilled through the plugs 611 is shown, in accordance with an embodiment. In an embodiment, the second holes 652 may be formed with a laser drilling process. In an embodiment, the second holes 652 result in the conversion of the plugs 611 into sleeves 614. In an embodiment, the interior surface of the sleeves 614 may be substantially vertical, as shown in Figure 6D, or the interior surface of the sleeves 614 may be tapered.

Referring now to Figure 6E, a cross-sectional illustration of the core 610 after vias 616 are formed within the sleeves 614 is shown, in accordance with an embodiment. In an embodiment, the vias 616 may be dummy vias. In other embodiments, the vias 616 may be part of the power delivery of the electronic package. As shown, pads 618 may be provided over the top and bottom surfaces of the vias 616 and sleeves 614. That is, the pads 618 may directly contact a portion of the sleeves 614 in some embodiments.

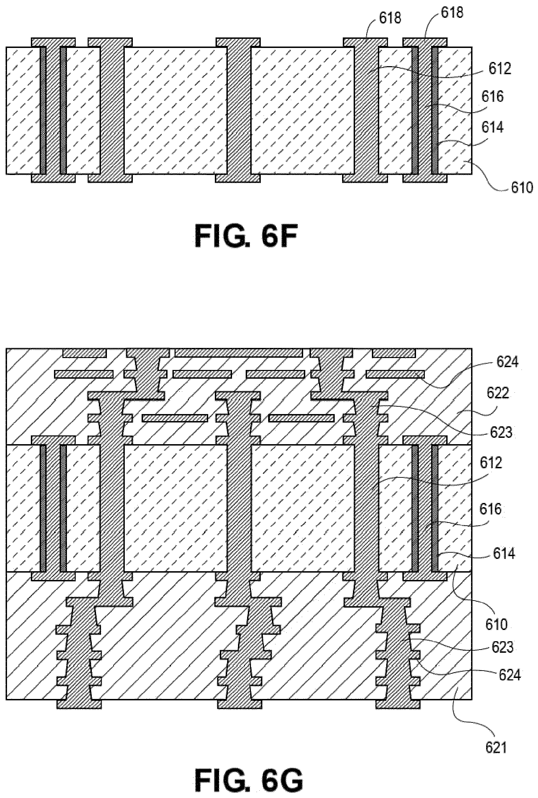

Referring now to Figure 6F, a cross-sectional illustration of the core 610 after TGVs 612 are formed through the core 610 is shown, in accordance with an embodiment. In an embodiment, the TGVs 612 may be formed with processes similar to those described above with respect to the formation of vias 616. For example, holes are drilled into the core 610 (e.g., with a laser process), and the holes are plated to form the TGVs 612 within the holes. Pads 618 may then be formed over the top and bottom surfaces of the TGVs 612.

Referring now to Figure 6G, a cross-sectional illustration of the core 610 after buildup layers 622 are provided above the core 610 and buildup layers 621 are provided below the core 610 is shown, in accordance with an embodiment. In an embodiment, the buildup layers 622 and 621 may be deposited with a lamination process. In an embodiment, conductive routing is also provided in the buildup layers 622 and 621. For example vias 623 and traces/pads 624 are embedded within the buildup layers 622 and 621. The conductive features 623 and 624 may be formed with an SAP technique in some embodiments.

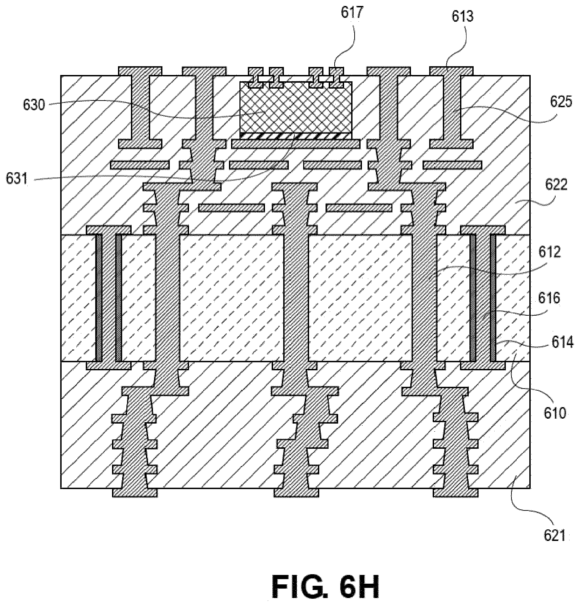

Referring now to Figure 6H, a cross-sectional illustration of the core 610 after a bridge die 630 is embedded in the buildup layers 622 is shown, in accordance with an embodiment. In an embodiment, the bridge die 630 is attached to a pad with a DAF 631. In the illustrated embodiment, the bridge die 630 is shown without through substrate vias. In other embodiments, the bridge die 630 may include through substrate vias. In such an embodiment, the backside of the bridge die 630 may be coupled to routing in the buildup layers 622 by solder balls or the like. In an embodiment, vias 625 may be formed adjacent to the bridge die 630. In an embodiment, pads 617 are formed over the bridge die 630, and pads 613 may be provided over the vias 625. The pads 617 and 613 may be formed with an SAP operation, in some embodiments.

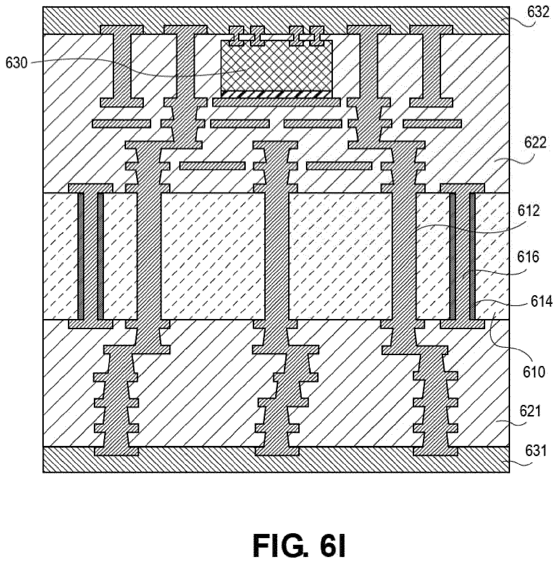

Referring now to Figure 6I, a cross-sectional illustration of the core 610 after solder resist layers 632 and 631 are provided over the top surface of the buildup layers 622 and the bottom surface of the buildup layers 621 is shown, in accordance with an embodiment. In an embodiment, the solder resist layers 632 and 631 may be deposited with a lamination process or the like. In an embodiment, the solder resist layers 632 and 631 may be cured in some embodiments.

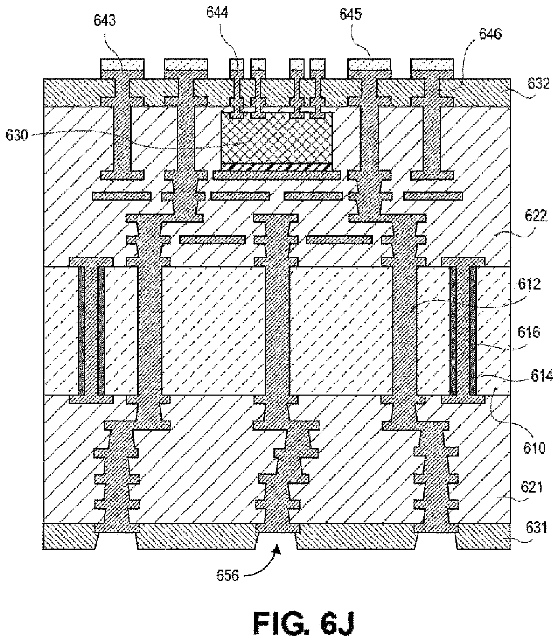

Referring now to Figure 6J, a cross-sectional illustration of the core 610 after FLIs are formed is shown, in accordance with an embodiment. As shown, vias 646 may pass through the solder resist 632. The vias 646 connect to pads 644 and 643 that are formed above the solder resist 632. In an embodiment, pads 644 are bridge pads and are coupled to the underlying bridge die 630. In an embodiment, the pads 644 and 643 may be plated with a surface finish (not shown). Additionally, a solder material 645 may be plated over the pads 644 and 643. In an embodiment, openings 656 are formed through the bottom solder resist layer 631 to expose pads for the SLI pads. The SLI pads may have a surface finish (not shown).

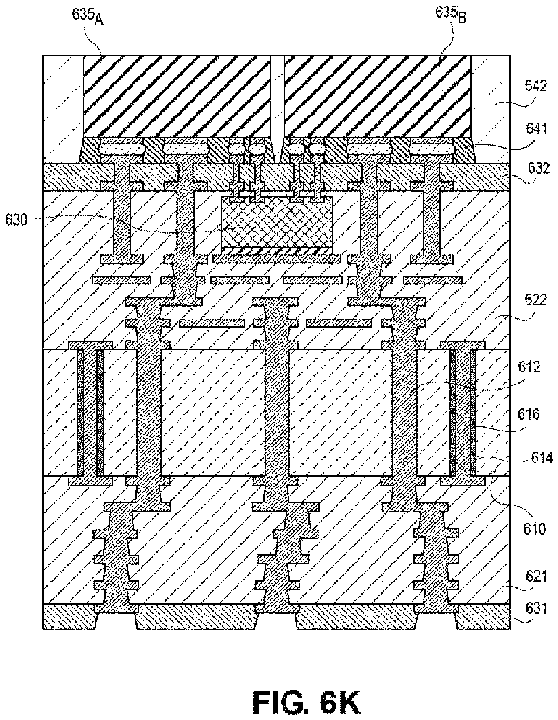

Referring now to Figure 6K, a cross-sectional illustration of the core 610 after a first die 635_{A} and a second die 635_{B} are attached is shown, in accordance with an embodiment. The dies 635 may be attached with the solder 645. In an embodiment, an underfill 641 may surround the solder 645. A mold layer 642 may be disposed around the dies 635. In an embodiment, the first die 635_{A} is communicatively coupled to the second die 635_{B} by the bridge die 630.

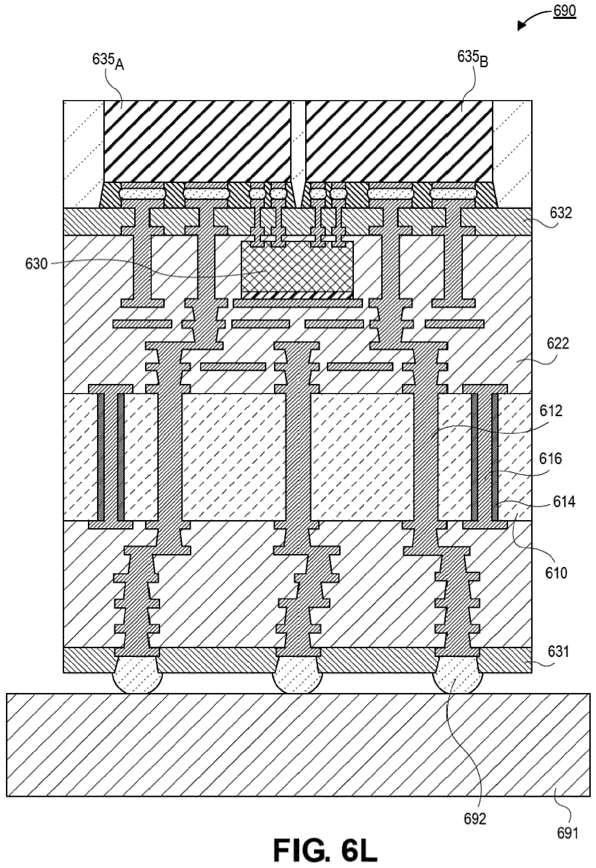

Referring now to Figure 6L, a cross-sectional illustration of an electronic system 690 is shown, in accordance with an embodiment. The electronic system 690 may comprise the structure shown in Figure 6K attached to a board 691, such as a PCB. In an embodiment, the board 691 may be coupled to the package substrate by SLIs 692. In an embodiment, the SLISs 692 comprise a solder ball, but it is to be appreciated that other SLI architectures may also be used in some embodiments.

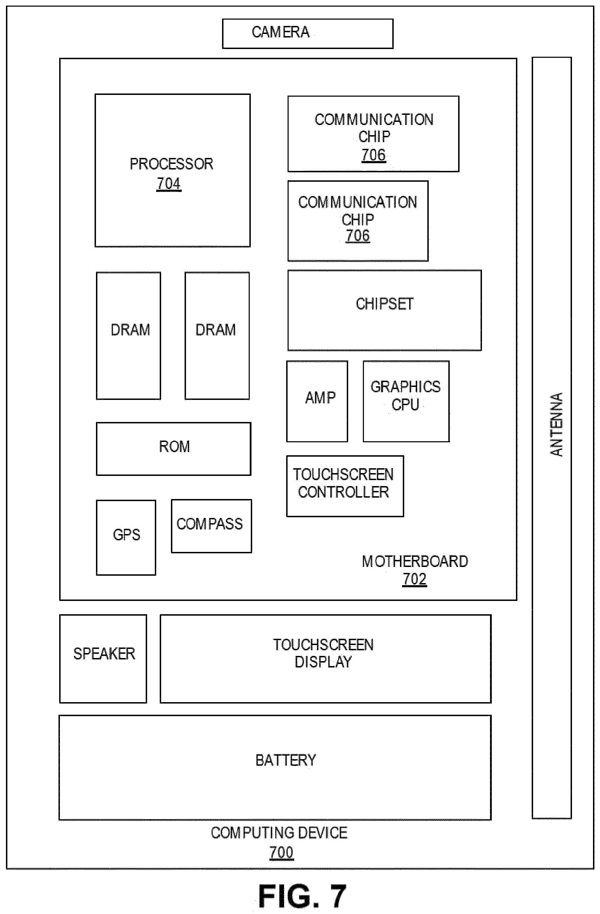

Figure 7 illustrates a computing device 700 in accordance with one implementation of the invention. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the invention, the integrated circuit die of the processor may be part of an electronic package that comprises a glass core with a barrier for mitigating crack propagation and/or a thermally conductive sleeve for improving thermal conductivity through the glass core, in accordance with embodiments described herein. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the invention, the integrated circuit die of the communication chip may be part of an electronic package that comprises a glass core with a barrier for mitigating crack propagation and/or a thermally conductive sleeve for improving thermal conductivity through the glass core, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: an electronic package, comprising: a core, wherein the core comprises glass; a hole through a thickness of the core; a plug filling the hole, wherein the plug comprises a polymeric material; first layers over the core, wherein the first layers comprise a dielectric material; and second layers under the core, wherein the second layers comprise the dielectric material.

Example 2: the electronic package of Example 1, further comprising a plurality of holes and a plurality of plugs.

Example 3: the electronic package of Example 2, wherein the plurality of plugs are positioned proximate to a perimeter of the core.

Example 4: the electronic package of Examples 1-3, wherein the hole is a continuous trench that is provided proximate to a perimeter of the core.

Example 5: the electronic package of Examples 1-4, further comprising: a via through the plug, wherein the via comprises a conductive material.

Example 6: the electronic package of Examples 1-5, further comprising: a bridge die embedded in the first layers over the core; a first die; and a second die, wherein the bridge die communicatively couples the first die to the second die.

Example 7: the electronic package of Example 6, wherein through silicon vias are formed through the bridge die.

Example 8: the electronic package of Examples 1-7, wherein a coefficient of thermal expansion (CTE) of the plug is between a CTE of the core and a CTE of copper.

Example 9: the electronic package of Examples 1-8, wherein the plug is a resin or an epoxy.

Example 10: the electronic package of Examples 1-9, wherein a crack in the core initiates at a via through the core and ends at the plug.

Example 11: a method of forming an electronic package, comprising: forming first holes through a core, wherein the core comprises glass; disposing plugs in the first holes; forming second holes through the core; and filling the second holes with vias, wherein the vias are conductive.

Example 12: the method of Example 11, further comprising: forming third holes through the plug.

Example 13: the method of Example 12, further comprising: filling the third holes with second vias, wherein the second vias are conductive.

Example 14: the method of Examples 11-14, wherein the first holes are proximate to a perimeter of the core.

Example 15: the method of Examples 11-14, wherein a crack in the core initiates at an individual one of the second holes, and wherein the crack propagates to and ends at an individual one of the plugs.

Example 16: the method of Examples 11-15, further comprising: forming first layers over the core; and forming second layers under the core.

Example 17: the method of Example 16, wherein a bridge die is embedded in the first layers over the core.

Example 18: an electronic system, comprising: a board; a package substrate coupled to the board, wherein the package substrate comprises: a core, wherein the core comprises glass; a hole through a thickness of the core; a plug filling the hole, wherein the plug comprises a polymeric material; first layers over the core, wherein the first layers comprise a dielectric material; and second layers under the core, wherein the second layers comprise the dielectric material; and a die coupled to the package substrate.

Example 19: the electronic system of Example 18, further comprising: a via through the plug, wherein the via comprises a conductive material.

Example 20: the electronic system of Example 18 or Example 19, wherein the hole is a continuous trench that is provided proximate to a perimeter of the core.

## Claims

1. An electronic package, comprising:
a core, wherein the core comprises glass;
a hole through a thickness of the core;
a plug filling the hole, wherein the plug comprises a polymeric material;
first layers over the core, wherein the first layers comprise a dielectric material; and
second layers under the core, wherein the second layers comprise the dielectric material.

2. The electronic package of claim 1, further comprising a plurality of holes and a plurality of plugs.

3. The electronic package of claim 2, wherein the plurality of plugs are positioned proximate to a perimeter of the core.

4. The electronic package of claim 1, 2 or 3, wherein the hole is a continuous trench that is provided proximate to a perimeter of the core.

5. The electronic package of claim 1, 2, 3 or 4, further comprising:
a via through the plug, wherein the via comprises a conductive material.

6. The electronic package of claim 1, 2, 3,4 or 5, further comprising:
a bridge die embedded in the first layers over the core;
a first die; and
a second die, wherein the bridge die communicatively couples the first die to the second die.

7. The electronic package of claim 6, wherein through silicon vias are formed through the bridge die.

8. The electronic package of claim 1, 2, 3, 4, 5, 6 or 7, wherein a coefficient of thermal expansion (CTE) of the plug is between a CTE of the core and a CTE of copper.

9. The electronic package of claim 1, 2, 3, 4, 5, 6, 7 or 8, wherein the plug is a resin or an epoxy.

10. The electronic package of claim 1, 2, 3, 4, 5, 6, 7, 8 or 9, wherein a crack in the core initiates at a via through the core and ends at the plug.

11. A method of forming an electronic package, comprising:
forming first holes through a core, wherein the core comprises glass;
disposing plugs in the first holes;
forming second holes through the core; and
filling the second holes with vias, wherein the vias are conductive.

12. The method of claim 11, further comprising:
forming third holes through the plug.

13. The method of claim 12, further comprising:
filling the third holes with second vias, wherein the second vias are conductive.

14. The method of claim 11, 12 or 13, wherein the first holes are proximate to a perimeter of the core.

15. The method of claim 11, 12, 13, or 14, wherein a crack in the core initiates at an individual one of the second holes, and wherein the crack propagates to and ends at an individual one of the plugs.
